Europäisches Patentamt

European Patent Office

Office européen des brevets

(11) Publication number: **0 225 837**
**B1**

(12) **EUROPEAN PATENT SPECIFICATION**

(45) Date of publication of patent specification: **16.05.90**

(21) Application number: **86630158.3**

(22) Date of filing: **30.10.86**

(51) Int. Cl.⁵: **C 30 B 11/00,** C 30 B 29/52

(54) **High strength single crystal superalloys.**

(30) Priority: **01.11.85 US 794025**

(43) Date of publication of application:
**16.06.87 Bulletin 87/25**

(45) Publication of the grant of the patent:
**16.05.90 Bulletin 90/20**

(84) Designated Contracting States:
**DE FR GB**

(56) References cited:
**EP-A-0 150 917**
**FR-A-2 374 427**

(73) Proprietor: **UNITED TECHNOLOGIES CORPORATION**
**United Technologies Building 1, Financial Plaza Hartford, CT 06101 (US)**

(72) Inventor: **Chin, Stephen**
**9 Templeton Road**
**Wallingford Connecticut 06492 (US)**
Inventor: **Duhl, David N.**
**31 Beacon Street**
**Newington Connecticut 06111 (US)**

(74) Representative: **Schmitz, Jean-Marie et al**
**OFFICE DENNEMEYER S.à.r.l. P.O. Box 1502**
**L-1015 Luxembourg (LU)**

Courier Press, Leamington Spa, England.

**Description**

This invention relates to nickel base superalloys, and in particular, to single crystal nickel base superalloys for use in gas turbine engines.

Nickel base superalloys have been extensively studied for many years. As a result, numerous alloys have been developed which display desireable properties under adverse operating conditions. Because of their properties, nickel base superalloys have found wide application in gas turbine engines. The following United States patents disclose some nickel base alloy compositions which have been developed for use in the gas turbine engine industry. All compositions are on a weight percent basis.

U.S. Patent No. 4,222,794 describes a single crystal nickel base superalloy having desireable high temperature mechanical properties and resistance to oxidation and hot corrosion. The composition of this alloy is 4.5—6.0 Cr, 0.0—7.0 Co, 1.7—2.3 Mo, 4.0—6.0 W, 1.0—5.0 Re, 5.0—5.8 Al, 0.8—1.5 Ti, 5.5—5.8 Ta, 0.2—0.6 V, with the balance nickel.

U.S. Patent No. 4,371,404 describes a single crystal nickel base superalloy whose composition is 6.5—8.2 Cr, 3.0—8.0 Co, 1.7—2.3 Mo, 3.0—5.0 W, up to 3.0 Re, 4.5—5.5 Al, 0.7—1.5 Ti, 10.0—13.5 Ta, with the balance nickel.

Other U.S. Patents which are indicative of the general state of the art relative to single crystal nickel base superalloys are U.S. Patent Nos. 4,116,723 and 4,402,772.

U.S. Patents which describe columnar grained nickel base superalloys are e.g., 3,526,499, 3,887,363, 3,904,402, 3,944,416, 4,169,742, 4,284,430, 4,292,076, 4,388,124, 4,522,664 and Re. 29,920. These superalloy compositions include grain boundary strengthening agents such as C, B and Zr. Single crystal nickel base superalloys such as those of the present invention achieve their desireable mechanical properties in the absence of such grain boundary strengthening elements.

This invention relates to superalloys suited for use at elevated temperatures, and in particular, to single crystal nickel base superalloys for gas turbine engines. The alloys of the present invention exhibit good creep strength, stable microstructures, and good oxidation and hot corrosion resistance. The composition of the alloys of the present invention is, on a weight percent basis, 4.0—5.5 Cr, 7.5—12.0 Co, 1.5—2.5 Mo, 1.0—6.0 W, 2.0—4.0 Re, 4.5—5.5 Al, 0.5—1.5 Ti, 8.0—12.0 Ta, with the balance nickel. The alloys may also include minor additions of V and Hf. The alloys contain no intentional additions of the elements B, Cb, C, or Zr, although these elements may be present as impurities.

The alloys are fabricated in single crystal form by known casting techniques; the cast component is then homogenized, or solutionized by heating at an elevated temperature, and the gamma prime strengthening phase $Ni_3(Al, Ti)$ precipitates on cooling from the solutionizing temperature.

When processed as described hereinbelow, the alloys of the present invention have an exceptional combination of properties. The combination of these properties, including mechanical strength at elevated temperatures and resistance to oxidation and hot corrosion makes the alloys suitable for use in high temperature sections of gas turbine engines.

The foregoing, and other objects, features and advantages of the present invention will become more apparent in the light of the following detailed description of the preferred embodiment thereof.

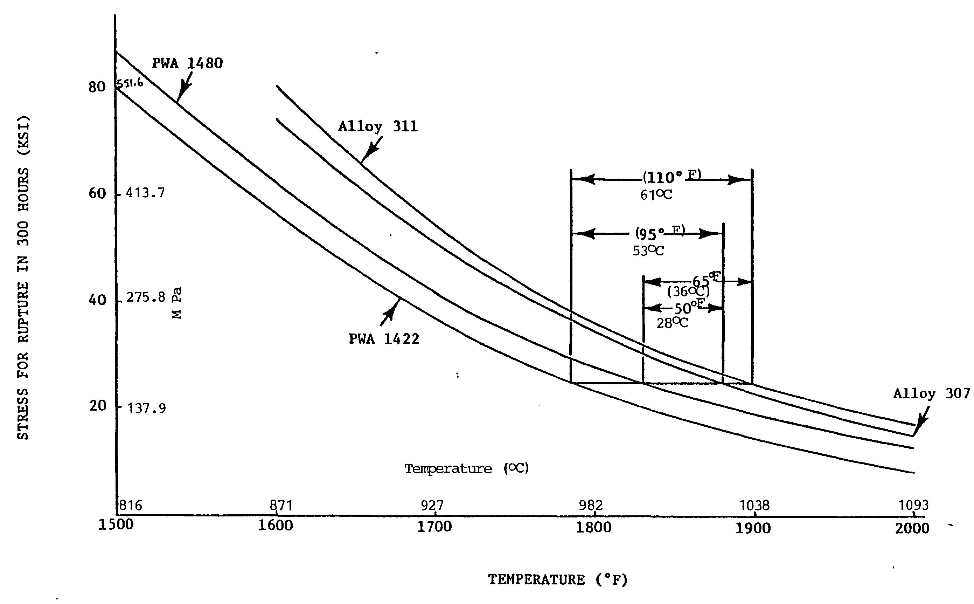

The Figure shows normalized stress rupture data plotted as a function of test temperature, comparing alloys of the present invention with two currently used nickel base superalloys.

The present invention relates to nickel base superalloys which have an exceptional combination of properties. The alloys have practical utility in single crystal form. Formation of the alloys into a single crystal is an important aspect of the invention, but the exact method and details of the single crystal formation are not critical. Solidification techniques which may be used are described in U.S. Patent No. 3,494,709.

The broad composition range for the alloys of the present invention is shown in Table I. Also shown in Table I are two preferred compositions which are within the broad range. These preferred compositions are hereinafter referred to as Alloy 307 and Alloy 311. While the alloys contain no intentional additions of B, Cb, C, or Zr, these elements may be present as impurities, in the levels indicated in the Table. Table I also presents the compositions of two nickel base superalloys which are currently used in gas turbine engines, and which were compared in laboratory tests with the alloys of the present invention. The alloy designated PWA 1422 in Table I has a columnar grain microstructure, while the alloy designated PWA 1480 has a single crystal microstructure. PWA 1480 is one of the strongest alloys known to Applicants from which airfoils currently used in gas turbine engines are fabricated.

2

EP 0 225 837 B1

Table I
Alloy Composition (Weight Percent)

| Element | Invention | | | Prior Art | |
|---|---|---|---|---|---|
| | Broad | Alloy 307 | Alloy 311 | PWA 1422 | PWA 1480 |
| Cr | 4.0– 5.5 | 4.6 | 5.1 | 9.0 | 10.0 |
| Co | 7.5–12.0 | 9.8 | 10.2 | 10.0 | 5.0 |
| Mo | 1.5– 2.5 | 1.8 | 2.0 | 0.0 | 0.0 |
| W | 1.0– 6.0 | 2.0 | 5.0 | 12.0 | 4.0 |
| Re | 2.0– 4.0 | 3.0 | 3.0 | 0.0 | 0.0 |
| Al | 4.5– 5.5 | 4.9 | 5.1 | 5.0 | 5.0 |
| Ti | 0.5– 1.5 | 1.0 | 0.92 | 2.0 | 1.5 |
| Ta | 8.0–12.0 | 11.9 | 9.1 | 0.0 | 12.0 |
| V | 0.0– 1.0 | 0.0 | 0.5 | 0.0 | 0.0 |
| Hf | 0.0– 0.5 | 0.0 | 0.1 | 2.0 | 0.0 |
| B | 0.0–0.01 | 0.0 | 0.0 | 0.015 | 0.0 |
| Cb | 0.0–0.2 | 0.0 | 0.0 | 1.0 | 0.0 |
| C | 0.0–0.05 | 0.0 | 0.0 | 0.1 | 0.0 |
| Zr | 0.0–0.01 | 0.0 | 0.0 | 0.0 | 0.0 |
| Ni | Balance | Balance | Balance | Balance | Balance |

Creep rupture tests were performed, at various test conditions, on Alloy 307 and Alloy 311 specimens, as well as on test specimens of the aforementioned, currrently used alloys PWA 1422 and PWA 1480. Results of these tests are presented in Table II. As is seen in the Table, in terms of rupture life, Alloy 307 has about seven times the life of PWA 1422 at all test conditions, and about 2.5 times the life of PWA 1480 at all test conditions. Table II also shows that Alloy 311 has about nine times the life of PWA 1422 and more than three times the life of PWA 1480. On the basis of the time to one percent creep, the alloys of the present invention exhibited strength advantages over the alloys PWA 1422 and PWA 1480 which were similar to their respective rupture life advantages.

Table II

Creep-Rupture Properties

| Alloy | Test Conditions | | 1% Creep Life (Hours) | Rupture Life (Hours) |
|---|---|---|---|---|
| 307 | 871$^O$C | 517.12MPa | 37 | 259 |
| 311 | 871$^O$C | 517.12MPa | --- | 440 |
| 1480 | 871$^O$C | 517.12MPa | 24 | 105 |
| 1422 | 871$^O$C | 517.12MPa | 8 | 40 |
| 307 | 982$^O$C | 248.22MPa | 95 | 242 |
| 311 | 982$^O$C | 248.22MPa | 122 | 283 |
| 1480 | 982$^O$C | 248.22MPa | 38 | 91 |
| 1422 | 982$^O$C | 248.22MPa | 10 | 33 |
| 307 | 1093$^O$C | 137.9MPa | --- | --- |
| 311 | 1093$^O$C | 137.9MPa | --- | 112 |
| 1480 | 1093$^O$C | 137.9MPa | 14 | 30 |
| 1422 | 1093$^O$C | 137.9MPa | 4 | 9 |
| 307 | 1093$^O$C | 124.1MPa | 31 | 120 |
| 311 | 1093$^O$C | 124.1MPa | -- | --- |
| 1480 | 1093$^O$C | 124.1MPa | 32 | 52 |
| 1422 | 1093$^O$C | 124.1MPa | 6 | 14 |

EP 0 225 837 B1

The Figure is a graphical representation of the data in Table II, after it has been normalized to a 300 hour rupture life. In the Figure, the stress to fracture a specimen in 300 hours is plotted as a function of test temperature. It is seen that Alloy 307 has about a 53°C (95°F) advantage over PWA 1422 at 172.37 MPa (25 ksi) and a 28°C (50°F) advantage over PWA 1480 at 172.37 MPa (25 ksi); similarly, Alloy 311 has about a 61°C (110°F) advantage over PWA 1422 at 172.37 MPa (25 ksi) and a 36°C (65°F) advantage over PWA 1480 at 172.37 MPa (25 ksi). The level of 172.37 MPa (25 ksi) can be used to approximate the steady state stress which a turbine airfoil might be expected to experience in the hot section of a gas turbine engine. Thus, the Figure indicates that the alloys of the present invention have better creep strength than two currently used, state of the art nickel base superalloys.

A limiting factor in the use of superalloys in gas turbine engines is oxidation and hot corrosion degradation. Such attack is caused by the extremely harsh environment of the engine. While most superalloys have coatings applied to their surfaces to limit oxidation and hot corrosion, engine designers have long realized that a substrate material having no inherent resistance to environmental attack will not be useful. Thus, superalloy compositions are tailored to provide a desireable combination of mechanical properties and resistance to environmental attack.

To determine the oxidation resistance of the alloys of the present invention, uncoated test specimens were cycled between exposure at 1149°C (2 100°F) for 29 minutes and forced air cool for 1 minute. These tests were performed on Alloy 307, PWA 1422 and PWA 1480, and they indicated that, in terms of the number of hours to produce 25 μm (0.001 inch) of oxidation degradation in the substrate, Alloy 307 had about 2.6 times the oxidation resistance of PWA 1422, and about 60% of the oxidation resistance of PWA 1480. While no oxidation tests were conducted on Alloy 311, the high aluminum content in the alloy (5.1%) and hafnium content (0.1%) should result in the alloy having excellent oxidation resistance, perhaps even better oxidation resistance than Alloy 307.

To determine the uncoated hot corrosion resistance of the alloys of the present invention, isothermal tests at 899°C (1 650°F) were performed. To accelerate the hot corrosion mechanism, the specimens were coated with about 1 milligram per square centimeter of $Na_2SO_4$. These tests indicated that, on the basis of the number of hours to cause 25 μm (1 mil) of corrosion degradation, Alloy 307 had about 60% of the uncoated corrosion resistance of PWA 1422, and Alloy 311 had about 45% of the uncoated corrosion resistance of PWA 1422.

While these tests indicated that the uncoated environmental resistance of the alloys of the present invention is not as good as the resistance of two commercially used alloys, it should be reiterated that the alloys would, if used in a gas turbine engine, be protected by a coating for optimum oxidation and corrosion protection. One of the most useful of these protective coatings is the NiCiCrAlY overlay described in U.S. Patent No. 3928 026, which may be applied by a vapor deposition process.

Turbine airfoils are commonly exposed to temperatures of about 1093°C (2 000°F); in some applications, exposure to even higher temperatures occurs. To examine the microstructural stability of the alloys of the present invention, tests were conducted to evaluate their behavior when exposed to 871, 982, 1093°C (1 600, 1 800 and 2 000°F) for periods up to 1000 hours. Metallographic examination of Alloy 307 specimens indicated that after these thermal exposures, there was no precipitation of undesireable phases such as sigma, mu, or Laves, which could degrade physical properties. Examination of Alloy 311 specimens after thermal exposure indicated only slight precipitation of such phases after 1 000 hours at 982 and 1093°C (1800 and 2000°F). These tests indicate that the alloys of the present invention may have sufficient microstructural stability to withstand the high temperatures which would be experienced by an airfoil in the turbine section of a gas turbine engine.

The alloys of the present invention, being single crystal in structure, derive their strength primarily due to the distribution of the intermetallic gamma prime phase $Ni_3(Al, Ti)$ within the solid solution gamma phase matrix. For a constant volume fraction of gamma prime, considerable variations in strength may be achieved by varying the size and morphology of the gamma prime precipitate within the gamma matrix.

These variations are achieved by heat treating the alloys to dissolve into solution with the matrix all or part of the gamma prime, and then reprecipitating the gamma prime as the alloys cook from the solutioning temperature. The ability to optimally heat treat single crystal alloys is a function of the difference between the alloy incipient melting temperature and the gamma prime solvus temperature. Solutioning of all of the ascast gamma prime phase is commercially practicable if the difference between the incipient melting temperature and the gamma prime solvus temperature is positive. Preferably the difference should be at least about 8°C (15°F). Laboratory tests indicated that Alloy 307 had an incipient melting temperature of 1324°C (2415°F), and a gamma prime solvus temperature of 1313°C (2395°F); thus Alloy 307 has a 11°C (20°F) solution heat treatment range. These tests also indicated that Alloy 311 had an incipient melting temperature of 1316°C (2400°F) and a gamma prime solvus temperature of 1296°C (2365°F); thus, Alloy 311 has a 20°C (35°F) solution heat treatment range.

In the alloys of the present invention, the gamma prime phase typically has a cuboidal shape; these alloys will have optimum mechanical properties if, in the heat treated condition, the average gamma prime size (cube edge dimension) is less than about 0.5 microns. Such a microstructure can be achieved by solutioning above the gamma prime solvus temperature but below the incipient melting temperature for about 4 hours, and then cooling at a rate of about 64°C (115°F) per minute until about 1093°C (2000°F). The single crystal articles may then be cooled to room temperature at a rate equal to, or greater than, air cool.

# EP 0 225 837 B1

Finally, the articles are given an aging treatment at about 871°C (1600°F) for 32 hours. For Alloy 307, an appropriate solutioning temperature would be about 1321°C (2410°F), while an appropriate solutioning temperature for Alloy 311 would be about 1299°C (2370°F).

**Claims**

1. An alloy composition suitable for casting into a single crystal nickel base superalloy article, characterized by the alloy composition consisting of, on a weight percent basis, 4—5.5 Cr, 7.5—12.0 Co, 1.5—2.5 Mo, 1—6 W, 2—4 Re, 4.5—5.5 Al, 0.5—1.5 Ti, 8—12 Ta, 0—1 V, 0—0.5 Hf, 0.0—0.01 B, 0.0—0.2 Cb, 0.0—0.05 C, 0.0—0.01 Zr, with the balance nickel plus impurities.

2. A heat treated single crystal nickel base superalloy article, characterized in consisting of, by weight percent, 4—5.5 Cr, 7.5—12 Co, 1.5—2.5 Mo, 1—6 W, 2—4 Re, 4.5—5.5 Al, 0.5—1.5 Ti, 8—12 Ta, 0—1 V, 0—0.5 Hf, 0.0—0.01 B, 0.0—0.2 Cb, 0.0—0.05 C, 0.0—0.01 Zr, with the balance nickel plus impurities.

3. The article of claim 2, characterized in having an average gamma prime particle size less than about 0.5 micrometers.

4. A method for producing a heat treated single crystal superalloy article, characterized in comprising the steps of:

(a) providing a composition consisting of 4—5.5 Cr, 7.5—12 Co, 1.5—2.5 Mo, 1—6 W, 2—4 Re, 4.5—5.5 Al, 0.5—1.5 Ti, 8—12 Ta, 0—1 V, 0—0.5 Hf, 0.0—0.01 B, 0.0—0.2 Cb, 0.0—0.05 C, 0.0—0.01 Zr, with the balance nickel plus impurities;

(b) melting and solidifying the composition to produce a single crystal article;

(c) solutioning the article between about 1299°C and 1321°C (2370°F and 2410°F) for about 4 hours;

(d) cooling the article from the solutioning temperature at a rate of at least 64°C (115°F) per minute, so as to precipitate gamma prime phase having an average size of less than 0.5 micrometers; and

(e) aging the article at about 871°C (1 600°F) for 32 hours.

**Patentansprüche**

1. Legierungszusammensetzung, die zum Gießen eines Einkristallnickelsuperlegierungsgegenstands geeignet ist, dadurch gekennzeichnet, daß die Legierungszusammensetzung in Gewichtsprozent aus 4—5,5 Cr, 7,5—12 Co, 1,5—2,5 Mo, 1—6 W, 2—4 Re, 4,5—5,5 Al, 0,5—1,5 Ti, 8—12 Ta, 0—1 V, 0—0,5 Hf, 0,0—0,01 B, 0,0—0,2 Nb, 0,0—0,05 C, 0,0—0,01 Zr, Rest Nickel plus Verunreinigungen, besteht.

2. Wärmebehandelter Einkristallnickelsuperlegierungsgegenstand, dadurch gekennzeichnet, daß er in Gewichtsprozent aus 4—5,5 Cr, 7,5—12 Co, 1,5—2,5 Mo, 1—6 W, 2—4 Re, 4,5—5,5 Al, 0,5—1,5 Ti, 8—12 Ta, 0—1 V, 0—0,5 Hf, 0,0—0,01 B, 0,0—0,2 Nb, 0,0—0,05 C, 0,0—0,01 Zr, Rest Nickel plus Verunreinigungen, besteht.

3. Gegenstand nach Anspruch 2, dadurch gekennzeichnet, daß er eine mittlere Gamma-Strich-Teilchengröße von winiger als etwa 0,5 Mikrometer hat.

4. Verfahren zum Herstellen eines wärmebehandelten Einkristallsuperlegierungsgegenstands, gekennzeichnet durch folgende Schritte:

a) Herstellen einer Zusammensetzung, die aus 4—5,5 Cr, 7,5—12 Co, 1,5—2,5 Mo, 1—6 W, 2—4 Re, 4,5—5,5 Al, 0,5—1,5 Ti, 8—12 Ta, 0—1 V, 0—0,5 Hf, 0,0—0,01 B, 0,0—0,2 Nb, 0,0—0,05 C, 0,0—0,01 Zr, Rest Nickel plus Verunreinigungen, besteht;

b) Schmelzen und Erstarrenlassen der Zusammensetzung, um einen Einkristallgegenstand herzustellen;

c) Lösungsglühen des Gegenstands zwischen etwa 1299°C und 1321°C (2370°F und 2410°F) für etwa 4 Stunden;

d) Abkühlen des Gegenstands ab der Lösungsglühtemperatur mit eine Geschwindigkeit von wenigstens 64°C (115°F) pro Minute, so daß Gamma-Strich-Phase ausgeschieden wird, die eine mittlere Größe von weniger als 0,5 Mikrometer hat; und e) Altern des Gegenstands bei etwa 871°C (1600°F) für 2 Stunden.

**Revendications**

1. Composition d'alliage appropriée pour la coulée en article en superalliage monocristallin à base de nickel caractérisée en ce que cette composition d'alliage est constituée, sur une base de pour cent en poids, de 4,0—5,5 Cr, 7,5—12,0 Co, 1,5—2,5 Mo, 1,0—6,0 W, 2,0—4,0 Re, 4,5—5,5 Al, 0,5—1,5 Ti, 8,0—12,0 Ta, 0—1 V, 0—0,5 Hf, 0,0—0,01 B, 0,0—0,2 Cb, 0,0—0,05 C, 0,0—0,01 Zr, le reste étant du nickel plus des impuretés.

2. Article traité et revenu en superalliage monocristallin à base de nickel, caractérisé en ce qu'il est constitué, sur une base de pour cent en poids, de 4,0—5,5 Cr, 7,5—12,0 Co, 1,5—2,5 Mo, 1,0—6,0 W, 2,0—4,0 Re, 4,5—5,5 Al, 0,5—1,5 Ti, 8,0—12,0 Ta, 0—1 V, 0—0,5 Hf, 0,0—0,01 B, 0,0—0,2 Cb, 0,0—0,05 C, 0,0—0,01 Zr, le reste étant du nickel plus des impuretés.

3. Article selon la revendication 2, caractérisé en ce qu'il a une granularité moyenne de phase gamma prime inférieure à environ 0,5 micrométres.

4. Procédé destiné à préparer un article trempé et revenu en superalliage monocristallin, ce procédé étant caractérisé en ce qu'il comprend les etapes consistant à:

(a) obtenir une composition constituée, sur une base de pour cent en poids, de 4,0—5,5 Cr, 7,5—12,0 Co, 1,5—2,5 Mo, 1,0—6,0 W, 2,0—4,0 Re, 4,5—5,5 Al, 0,5—1,5 Ti, 8,0—12,0 Ta, 0—1 V, 0—0,5 Hf, 0,0—0,01 B, 0,0—0,2 Cb, 0,0—0,05 C, 0,0—0,01 Zr, le reste étant du nickel plus des impuretés;

(b) couler et solidifier la composition pour obtenir un article monocristallin;

(c) soumettre l'article à un recuit de mise en solution entre environ 1299°C et 1321°C (2370°F et 2410°F) pendant environ 4 heures;

(d) refroidir l'article à partir de la température de mise en solution à une vitesse d'au moins 64°C (115°F) par minute, de façon à précipiter la phase gamma prime ayant une granularité moyenne inférieure à 0,5 micromètres; et

(e) durcir l'article par précipitation à une température d'environ 871°C (1600°F) pendant 32 heures.